Europäisches Patentamt

European Patent Office

Office européen des brevets

(11) Publication number: 0 490 246 A1

# EUROPEAN PATENT APPLICATION

(21) Application number: 91120789.2

(22) Date of filing: 03.12.91

(51) Int. Cl.5: H01L 27/148

(30) Priority: 11.12.90 JP 410040/90

(43) Date of publication of application:
17.06.92 Bulletin 92/25

(84) Designated Contracting States:
DE FR GB

(71) Applicant: SONY CORPORATION
7-35, Kitashinagawa 6-chome Shinagawa-ku
Tokyo(JP)

(72) Inventor: Kobayashi, Atsushi
c/o Sony Corporation 7-35 Kitashinagawa
6-chome
Shinagawa-ku Tokyo(JP)

(74) Representative: TER MEER - MÜLLER -
STEINMEISTER & PARTNER
Mauerkircherstrasse 45
W-8000 München 80(DE)

(54) Solid-state imager.

(57) In a solid-state (A) imager having a vertical transfer register (1) formed of electrodes (5, 6, 7) of three layers, charges are read out from the electrode (7) of the third layer and upon this reading operation, a voltage of low level is supplied to the electrode (5) of the first layer, a voltage of high level is supplied to the electrode (6) of the second layer and a read out pulse is supplied to the electrode (7) of the third layer. With solid-state imager of the construction, a potential difference between the electrodes forming the vertical transfer register can be reduced, whereby the oxide films (8, 9, 10) among the respective electrodes can be reduced in thickness and also the charge transfer can be restrained from being deteriorated.

FIG. 3

## BACKGROUND OF THE INVENTION

### Field of the Invention

The present invention generally relates to charge-coupled devices and, more particularly, is directed to a solid-state imager in which a vertical transfer register is composed of electrodes of three layers formed of polycrystalline silicon layers, for example.

### Description of the Prior Art

A solid-state imager in which a vertical transfer register is composed of electrodes of three layers formed of polycrystalline silicon layers is generally constructed in the manufacturing processes shown in FIGS. 1A to 1C.

As shown in FIG. 1A, an N type impurity diffusion region band 22 is formed on a silicon substrate 21 of, for example, P type and then an insulating film 23 made of $SiO_2$ or the like is formed on the whole surface of the N type impurity diffusion region band 22. Thereafter, an electrode 24 of the first layer formed of a polycrystalline silicon layer is formed on a predetermined portion of the insulating film 23.

Then, as shown in FIG. 1B, the whole surface is thermally oxidized to form a thin oxide film 25 on the surface of the electrode 24 of the first layer, and then an electrode 26 of the second layer formed of a polycrystalline silicon layer is formed on the surface such that one portion thereof is formed on the electrode 24 of the first layer.

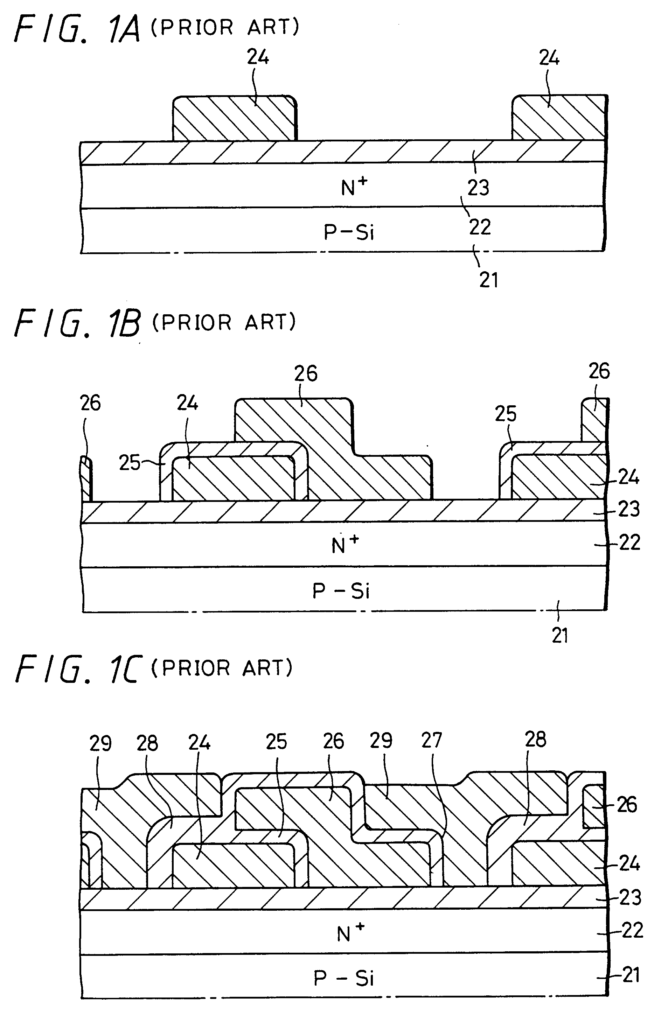

Then, as shown in FIG. 1C, the whole surface is thermally-oxidized again to form a thin oxide film 27 on the electrode 26 of the second layer. At that time, the thermal oxidation on the surface of the electrode 24 of the first layer further proceeds to increase the thickness of the oxide film 25 formed on the surface of the electrode 24 of the first layer at its portion in which the electrode 26 of the second layer is not formed, thereby forming a thick oxide film 28. Then, as shown in FIG. 1C, an electrode 29 of the third layer formed of a polycrystalline silicon layer is formed on the surface in such a manner that one portion thereof is formed on the electrode 24 of the first layer and the electrode 26 of the second layer.

Then, as shown in FIG. 2A, the whole surface is thermally oxidized again to form an oxide film 30 on the surface of the electrode 29 of the third layer, thereby obtaining a solid-state imager B in which the electrodes 24, 26 and 29 of the three layers constitute a vertical transfer register 31.

When photoelectrically-converted charges are read by a sensor unit (not shown) of this solid-state imager, the charges can be read by applying a read-out pulse to one electrode and by applying voltages of low and high levels to the remaining two electrodes in the vertical transfer register 31, respectively.

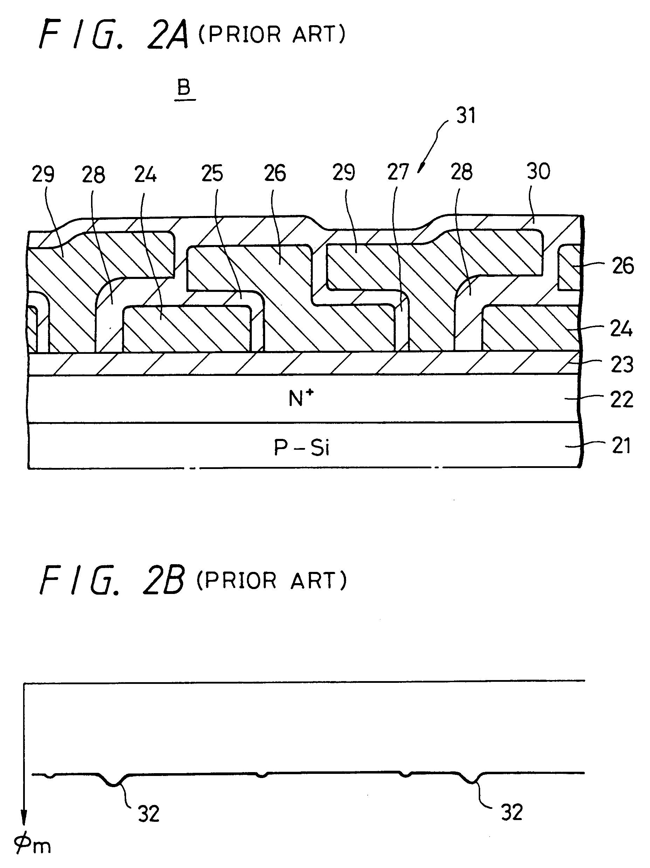

In the solid-state imager B, the thickness of the oxide film 25 between the electrode 24 of the first layer and the electrode 26 of the second layer, the thickness of the oxide film 28 between the electrode 24 of the first layer and the electrode 29 of the third layer and the thickness of the oxide film 27 between the electrode 26 of the second layer and the electrode 29 of the third layer are respectively different and, particularly, the thickness of the oxide film 28 between the electrode 24 of the first layer and the electrode 29 of the third layer is increased as compared with others. As a consequence, examining potential depths in the case such that the same potential is applied to all of the electrodes 24, 26 and 29, it is to be noted that, as shown in FIG. 2B, the potential depth between the electrode 24 of the first layer and the electrode 29 of the third layer is locally increased as compared with others. Thus, when charges are transferred vertically, then the transfer of charges from the electrode 24 of the first layer to the electrode 29 of the third layer or the transfer of charges from the electrode 29 of the third layer to the electrode 24 of the first layer becomes deteriorated and in addition, there is then the disadvantage such that charges are left in a deep localized potential portion 32.

To remove the above-mentioned disadvantage, it is proposed to reduce the thickness of the oxide film 28 between the electrode 24 of the first layer and the electrode 29 of the third layer. This proposal is not so preferable from a withstanding voltage standpoint because if the thickness of the oxide film 28 between the electrode 24 of the first layer and the electrode 29 of the third layer is reduced, then the thicknesses of the respective oxide films 25 and 27 between the electrode 24 of the first layer and the electrode 26 of the second layer and between the electrode 26 of the second layer and the electrode 29 of the third layer are unavoidably reduced, respectively.

More specifically, when charges accumulated, for example, in the sensor portion (not shown) are read-out to the vertical transfer register 31, the read-out pulse is supplied to one of the electrodes. In this case, since the read-out pulse is the voltage higher than the voltages of high level applied to other electrodes, a potential difference of more than 20 Volts takes place between it and other electrodes to which the voltages of low level are applied. This is why the withstanding voltage is insufficient if the oxide film, particularly, the oxide films 25 and 27 are thin in thickness.

## OBJECTS AND SUMMARY OF THE INVENTION

Accordingly, it is an object of the present invention to provide an improved solid-state imager in which the aforementioned shortcomings and disadvantages encountered with the prior art can be eliminated.

More specifically, it is an object of the present invention to provide a solid-state imager in which a potential difference among electrodes forming a vertical transfer register can be reduced.

Another object of the present invention is to provide a solid-state imager in which oxide films formed among respective electrodes can be reduced in thickness.

Still another object of the present invention is to provide a solid-state imager in which charge transfer can be restrained from being deteriorated.

As an aspect of the present invention, a solid-state imager having a vertical transfer register formed of electrodes of three layers. In this solid-state imager, charges are read out from the electrode of a first layer in which reading operation a voltage of low level is supplied to the electrode of the first layer, a voltage of high level is supplied to the electrode of a second layer and a read-out pulse is supplied to electrode of the third layer. According to this solid-state imager, a potential difference between the electrodes forming the vertical transfer register can be reduced, whereby the oxide films among the respective electrodes can be reduced in thickness and also the charge transfer can be restrained from being deteriorated.

The preceding and other objects, features and advantages of the present invention will become apparent from the following description of an illustrative embodiment thereof when read in conjunction with the accompanying drawings, in which like reference numerals are used to identify the same or similar parts in the several views.

## BRIEF DESCRIPTION OF THE DRAWINGS

FIGS. 1A to 1C are respectively process diagrams showing the ordinary manufacturing process of a vertical transfer register;

FIGS. 2A and 2B are respectively a longitudinal diagrammatic view of a section showing an example of a vertical transfer register according to the prior art and a potential diagram showing the case such that the same potential is applied to respective electrodes;

FIG. 3 is a longitudinal diagrammatic view of a section showing an arrangement of a main portion (i.e., vertical transfer register) of the solid-state imager according to an embodiment of the present invention;

FIG. 4 is a plan view of the main portion of FIG. 3 and, to which references will be made in explaining operation of the vertical transfer register of the embodiment;

FIG. 5 is a potential diagram showing operation of the vertical transfer register according to the embodiment such that charges are read-out and transferred by the vertical transfer register; and

FIG. 6 is a waveform diagram of respective clock pulses to which references will be made in explaining the operation of the vertical transfer register according to the embodiment such that charges are read-out and transferred by the vertical transfer register.

## DETAILED DESCRIPTION OF THE PREFERRED EMBODIMENT

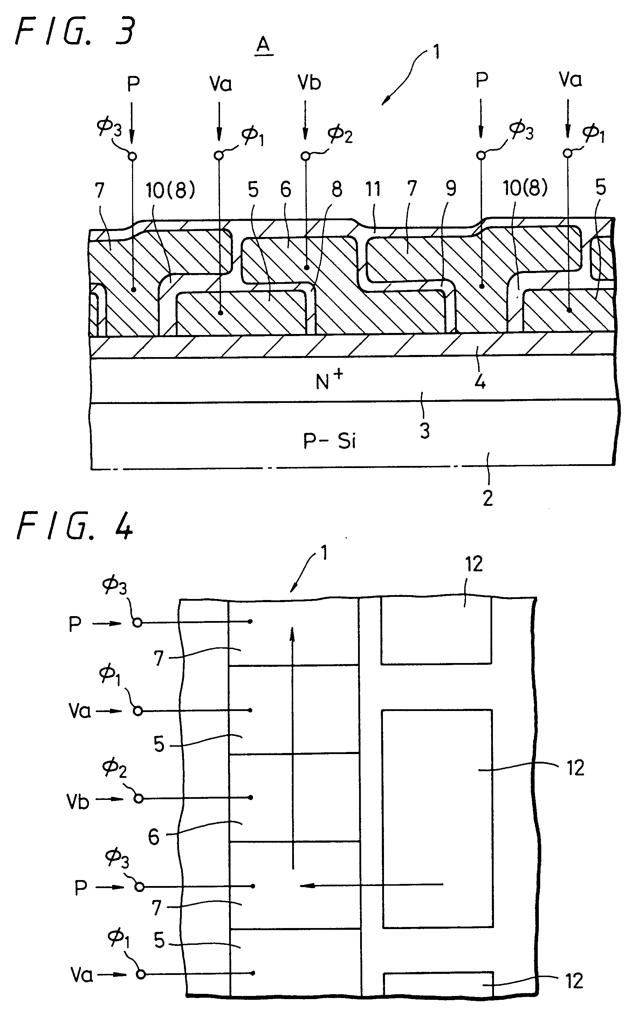

An embodiment of the solid-state imager according to the present invention will now be described with reference to FIGS. 3 through 6.

FIG. 3 is a longitudinal diagrammatic view of a section showing a main portion of a solid-state imager A employing, for example, a charge-coupled device (CCD) according to the embodiment of the present invention, particularly, its vertical transfer register 1.

In this vertical transfer register 1, as shown in FIG. 3, an insulating film 4 made of $SiO_2$ or the like is formed, for example, on an N type impurity diffusion region band 3 formed on a silicon substrate 2 of, for example, P type and electrodes 5, 6 and 7 of three layers formed of polycrystalline silicon layers are formed on the insulating film 4.

More specifically, the electrode 5 of the first layer of polycrystalline silicon is formed on a predetermined portion of the insulating film 4 by the patterning-process and then the whole surface is thermally oxidized to form an oxide film 8 on the surface of the electrode 5. Thereafter, the electrode 6 of the second layer of polycrystalline silicon is formed on the insulating film 4 by the patterning-process in such a fashion that one portion of the electrode 6 covers the electrode 5 of the first layer. Then, the whole surface is thermally oxidized to form an oxide film 9 on the surface of the electrode 6 of the second layer. At that time, the thermal oxidation on the surface of the electrode 5 of the first layer further proceeds to increase the thickness of the oxide film 8 formed on the surface of the electrode 5 of the first layer at its portion in which the electrode 6 of the second layer does not cover, so that it becomes a thick oxide film 10. Then, the electrode 7 of the third layer of polycrystalline silicon is formed on the insulating film 4 by the patterning-process such that one portion of the electrode 7 covers the electrode 5 of the first layer and the electrode 6 of the second layer. Thereafter, the whole surface is thermally oxidized to form an oxide film 11 on the surface of the electrode 7 of the third layer, thereby obtaining the vertical transfer register 1 of this embodiment.

According to the embodiment of the present invention, as shown in FIG. 4, when charges accumulated in a sensor portion 12 are read-out to the vertical transfer register 1, a read-out pulse P is applied to an input terminal $\phi3$ of the electrode 7 of the third layer, a voltage Va of low level is applied to an input terminal $\phi1$ of the electrode 5 of the first layer and a voltage Vb of high level is applied to an input terminal $\phi2$ of the electrode 6 of the second layer, whereby the charges are read-out by the electrode 7 of the third layer.

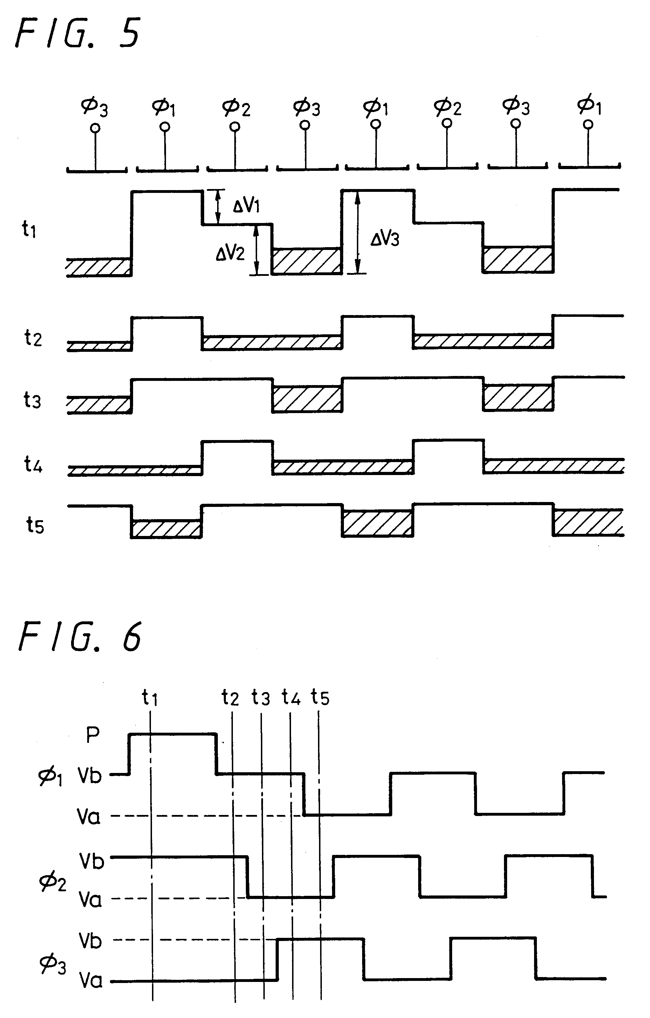

The charge read-out operation and the charge transfer operation will be described with reference to FIGS. 5 and 6.

Initially, at timing point t1, the voltage Va of low level is supplied to the input terminal $\phi1$ of the electrode 5 of the first layer, the voltage Vb of high level is supplied to the input terminal $\phi2$ of the electrode 6 of the second layer and the read-out pulse P is supplied to the input terminal $\phi3$ of the electrode 7 of the third layer, whereby the charge accumulated in the sensor portion 12 is read-out to the potential well formed below the electrode 7 of the third layer, thereby the charges being transferred to and accumulated under the electrode 7 of the third layer. In this embodiment, a potential relation among the voltages Va, Vb and the read-out pulse P is expressed by an inequality of $P > Vb > Va$. Accordingly, potential differences $\Delta V_1$ and $\Delta V_2$ between the electrode 5 of the first layer and the electrode 6 of the second layer and between the electrode 6 of the second layer 6 and the electrode 7 of the third layer in which the thin oxide films 8 and 9 are interposed are low as compared with a potential difference $\Delta V_3$ between the electrode 5 of the first layer and the electrode 7 of the third layer in which the thick oxide film 10 is interposed (i.e., $\Delta V_1 < \Delta V_3$, $\Delta V_2 < \Delta V_3$). Accordingly, the potential differences of magnitudes corresponding to the thicknesses of the oxide films 8, 9 and 10 are brought about, which relation is preferable from a withstanding voltage standpoint.

At the next timing point t2, the voltage Vb of high level is supplied to the input terminals $\phi3$ and $\phi2$ of the electrodes 7 and 6 of the third and second layers and the voltage Va of low level is supplied to the input terminal $\phi1$ of the electrode 5 of the first layer, whereby the charges are transferred to and accumulated under the electrodes 7 and 6 of the third and second layers.

At the next timing point t3, the voltage Vb of high level is supplied to the input terminal $\phi3$ of the electrode 7 of the third layer and the voltage Va of low level is supplied to the respective input terminals $\phi2$ and $\phi1$ of the electrodes 6 and 5 of the second and first layers, whereby the charges are transferred to and accumulated under the electrode 7 of the third layer again.

At the next timing t4, the voltage Vb of high level is supplied to the input terminals $\phi3$ and $\phi1$ of the electrodes 7 and 5 of the third and first layers and the voltage Va of low level is supplied to the input terminal $\phi2$ of the electrode 6 of the second layer, whereby the charges are transferred to and accumulated under the electrodes 7 and 5 of the third and first layers.

At the next timing t5, the voltage Va of low level is supplied to the input terminals $\phi3$ and $\phi2$ of the electrodes 7 and 6 of the third and second layers and the voltage Vb of high level is supplied to the input terminal $\phi1$ of the electrode 5 of the first layer, whereby the charges are transferred to and accumulated under the electrode 6 of the second layer.

As described above, by supplying the three-phase drive signal (voltages Va, Vb) to the electrode 5 of the first layer to the electrode 7 of the third layer, the charges read-out from the sensor portion 12 are sequentially transferred to from the under portion of the electrode 7 of the third layer through the under portion of the electrode 6 of the second layer to the under portion of the electrode 5 of the first layer, in that order. When the charges are transferred, the potential difference applied among the respective electrodes 5, 6 and 7 is the difference $\Delta V_1$ between the voltage Vb of high level and the voltage Va of low level and upon reading the charges this potential difference $\Delta V_1$ is lower than the potential difference $\Delta V_3$ applied between the electrode 5 of the first layer and the electrode 7 of the third layer. Accordingly, if the withstanding voltage is sufficient when the charge is read-out, then the withstanding voltage upon charge transfer will cause no problem.

As described above, according to this embodiment, when the charges are read-out in the application of the read-out pulse P of voltage higher than the voltage Vb of high level, since the read-out pulse P is supplied to the electrode 7 of the third layer, the voltage Va of low level is applied to the electrode 5 of the first layer in which the thickness of the oxide film 10 is relatively thick between it and the electrode 7 of the third layer and the voltage Vb of high level is applied to the electrode 6 of the second layer in which the thickness of the oxide film 9 is relatively thin between it and the electrode 7 of the third layer, the large potential difference $\Delta V_3$ can be avoided from being applied between the electrode 5 of the first layer and the electrode 6 of the second layer and between the electrode 6 of the second layer and the electrode 7 of the third layer where the thin oxide films 8 and 7 respectively exist. As a consequence, the thicknesses of the oxide films 8, 9 and 10 can be reduced on the whole and therefore the deterioration of the charge transfer due to the thicknesses of the oxide films 8, 9 and 10 among the respective electrodes 5, 6 and 7, particularly, due to the thickness of the oxide film 10 can be restrained.

According to the solid-state imager of the present invention, the potential difference among the electrodes constructing the vertical transfer resister can be reduced, the oxide film between the electrodes can be reduced in thickness and the deterioration of the charge transfer can be restrained.

Having described the preferred embodiment of the invention with reference to the accompanying drawings, it is to be understood that the invention is not limited to that precise embodiment and that various changes and modifications thereof could be effected by one skilled in the art without departing from the spirit or scope of the novel concepts of the invention as defined in the appended claim.

## Claims

1. A solid-state imager (A) in which a vertical transfer register (1) is formed of electrodes of three layers (5, 6, 7) **characterized in** that charges are read out from the electrode (7) of the third layer and upon this reading operation a voltage of low level is supplied to the electrode (5) of the first layer, a voltage of high level is supplied to the electrode (6) of the second layer and a read-out pulse is supplied to the electrode (7) of said third layer.

FIG. 1A (PRIOR ART)

FIG. 1B (PRIOR ART)

FIG. 1C (PRIOR ART)

# FIG. 2A (PRIOR ART)

B

29  28  24  25  26  29  27  31  28  30

26

24

23

N⁺ — 22

P – Si — 21

# FIG. 2B (PRIOR ART)

32      32

$\phi$m

FIG. 3

FIG. 4

# FIG. 5

# FIG. 6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 083 240 (TOKYO SHIBAURA DENKI KABUSHIKI KAISHA)<br>* page 20, line 8 - page 21, line 31; figures 15,16 * | 1 | H01L27/148 |
| A | PATENT ABSTRACTS OF JAPAN<br>vol. 8, no. 91 (E-241)(1528) 26 April 1984<br>& JP-A-59 009 963 ( MATSUSHITA DENKI SANGYO K. K. )<br>* abstract * | 1 | |
| A | SOLID-STATE CIRCUITS CONFERENCE, THE 1974 INTERNATIONAL; DIGEST OF TECHNICAL PAPERS, INSTITUTE OF ELECTRICAL AND ELECTRONICS ENGINEERS<br>1974, NEW YORK, USA<br>CARLO H. SEQUIN ET AL.: 'CHARGE-COUPLED IMAGE-SENSING DEVICES USING THREE LEVELS OF POLYSILICON (PAGES 24-25,218)'<br>* the whole document * | 1 | |
| A | EP-A-0 214 702 (N. V. PHILIPS' GLOEILAMPENFABRIEKEN)<br>* abstract * | 1 | **TECHNICAL FIELDS SEARCHED (Int. Cl.5 )**<br><br>H01L |
| A | PATENT ABSTRACTS OF JAPAN<br>vol. 8, no. 272 (E-284)(1709) 13 December 1984<br>& JP-A-59 143 361 ( HITACHI SEISAKUSHO K. K. )<br>* abstract * | 1 | |

The present search report has been drawn up for all claims

| Place of search | Date of completion of the search | Examiner |
|---|---|---|
| THE HAGUE | 30 MARCH 1992 | ONSHAGE A.C. |